# EUROPEAN PATENT APPLICATION

(11) **EP 4 478 397 A1**
(43) Date of publication of application: **18.12.2024**
(21) Application number: 22757815.0
(22) Date of filing: 14.02.2022

(54) **DISPLAY PANEL**

(30) Priority: 07.02.2022 CN 202210115922
(71) Applicant: Wuhan China Star Optoelectronics Semiconductor Display Technology Co., Ltd., Wuhan, Hubei 430079 (CN)
(72) Inventor: TANG, Rui, Wuhan, Hubei 430079 (CN)
(74) Representative: Patentanwälte Olbricht Buchhold Keulertz
(86) International application number: PCT/CN2022/076216
(87) International publication number: WO 2023/147710

(57) **Abstract**

A display panel includes a first display area and a second display area. The display panel includes a substrate, a light-emitting layer, and an optical structural layer. The light-emitting layer is disposed on the substrate and includes a plurality of first sub-pixels and a plurality of second sub-pixels. The optical structural layer is disposed on one side of the light-emitting layer away from the substrate, and a light concentrating ability of the optical structural layer corresponding to the first display area is less than a light concentrating ability of the optical structural layer corresponding to the second display area.

## Description

### FIELD OF INVENTION

The present disclosure relates to the field of display technologies, and more particularly, to a display panel.

### BACKGROUND OF INVENTION

Organic light-emitting diode (OLED) display panels have many advantages such as self-illumination, low driving voltages, high luminous efficiency, short response times, high clarity and contrast, having a viewing angle near 180 degrees, a wide range of operating temperature, and an ability to achieve flexible display and full color display in a large area. Therefore, the OLED display panels are recognized as an emerging application technology of next-generation flat-panel displays by the industry.

At present, OLED display panels having top-emission structures are commonly used, and a cathode structure of most of current products uses magnesium and silver alloys or a laminated structure thereof. Magnesium and silver metals have lower work function to ensure electron output efficiency, and meanwhile, silver has a certain reflection effect and forms a resonance cavity with an anode to ensure that light emitted from a light-emitting layer passes through the resonance cavity, thereby improving light extraction efficiency. In order to realize full screen display, cameras of current OLED display devices are disposed under display panels. When a camera function is used, a display function is turned off, and when the display function is used, an under-screen camera area displays, that is, a camera under panel (CUP) technique. However, regarding the OLED display panels having under-screen cameras, in light-emitting areas above a projection of the cameras, a light intensity will be lost by about 50% when external light passes through a cathode. A light loss of the cathode directly affects photo effects, so it is necessary to improve the cathode structure in this area to improve light transmittance. However, current display panels have a problem of brighter visual brightness at large viewing angles in the under-screen camera area than in a display area.

Therefore, it is necessary to provide a new technical solution to solve the above technical problems.

Technical problem: an embodiment of the present disclosure provides a display panel to solve a problem of brighter visual brightness at large viewing angles in a second display area that corresponds to a photosensitive electronic component than in a first display area.

### SUMMARY OF INVENTION

An embodiment of the present disclosure provides a display panel, which includes a first display area and a second display area, wherein, the first display area surrounds at least a part of the second display area. The display panel includes:
a substrate;
a light-emitting layer disposed on the substrate and including a plurality of first sub-pixels and a plurality of second sub-pixels, wherein, the first sub-pixels correspond to the first display area, and the second sub-pixels correspond to the second display area; and
an optical structural layer disposed on one side of the light-emitting layer away from the substrate, wherein, a light concentrating ability of the optical structural layer corresponding to the first display area is less than a light concentrating ability of the optical structural layer corresponding to the second display area.

In the display panel provided by an embodiment of the present disclosure, at a predetermined distance, an irradiation range of light emitted from the first sub-pixels and passing through the optical structural layer corresponding to the first display area is a first irradiation range, and an irradiation range of light emitted from the second sub-pixels and passing through the optical structural layer corresponding to the second display area is a second irradiation range; and
the first irradiation range is greater than the second irradiation range.

In the display panel provided by an embodiment of the present disclosure, the optical structural layer includes a first optical film layer and a second optical film layer, and a refractive index of the first optical film layer is less than a refractive index of the second optical film layer; and the first optical film layer includes a plurality of first openings and a plurality of second openings, the first openings correspond to the first sub-pixels, the second openings correspond to the second sub-pixels, and the second optical film layer is disposed on one side of the first optical film layer away from the light-emitting layer and filled in the first openings and the second openings.

In the display panel provided by an embodiment of the present disclosure, an orthographic projection of the first sub-pixels on the substrate has a first width, an orthographic projection of the first openings on the substrate has a second width, the second width is greater than the first width, and a difference value between the second width and the first width is a first difference value;
an orthographic projection of the second sub-pixels on the substrate has a third width, an orthographic projection of the second openings on the substrate has a fourth width, the fourth width is greater than the third width, and a difference value between the fourth width and the third width is a second difference value; and
the first difference value is greater than the second difference value.

In the display panel provided by an embodiment of the present disclosure, the first difference value is greater than 1.5 µm and is less than or equal to 5 µm, and the second difference value is less than or equal to 1.5 µm.

In the display panel provided by an embodiment of the present disclosure, a first included angle is defined between the first openings and a bottom surface of the first optical film layer, a second included angle is defined between the second openings and the bottom surface of the first optical film layer, the first included angle and the second included angle are both less than 90 degrees, and the first included angle is less than or equal to the second included angle.

In the display panel provided by an embodiment of the present disclosure, a first included angle is defined between the first openings and a bottom surface of the first optical film layer, a second included angle is defined between the second openings and the bottom surface of the first optical film layer, the first included angle and the second included angle are both less than 90 degrees, and the first included angle is less than the second included angle.

In the display panel provided by an embodiment of the present disclosure, the first included angle is greater than or equal to 15° and is less than or equal to 60°, and the second included angle is greater than 60° and less than 90°.

In the display panel provided by an embodiment of the present disclosure, an orthographic projection of the first sub-pixels on the substrate has a first width, an orthographic projection of the first openings on the substrate has a second width, the second width is greater than the first width, and a difference value between the second width and the first width is a first difference value;
an orthographic projection of the second sub-pixels on the substrate has a third width, an orthographic projection of the second openings on the substrate has a fourth width, the fourth width is greater than the third width, and a difference value between the fourth width and the third width is a second difference value; and
the first difference value is greater than or equal to the second difference value.

In the display panel provided by an embodiment of the present disclosure, a refractive index of the second optical film layer corresponding to the first display area is less than a refractive index of the second optical film layer corresponding to the second display area.

In the display panel provided by an embodiment of the present disclosure, the refractive index of the second optical film layer corresponding to the first display area is greater than or equal to 1.25 and is less than or equal to 1.65, and the refractive index of the second optical film layer corresponding to the second display area is greater than or equal to 1.5 and is less than or equal to 1.9.

In the display panel provided by an embodiment of the present disclosure, an orthographic projection of the first sub-pixels on the substrate has a first width, an orthographic projection of the first openings on the substrate has a second width, the second width is greater than the first width, and a difference value between the second width and the first width is a first difference value;
an orthographic projection of the second sub-pixels on the substrate has a third width, an orthographic projection of the second openings on the substrate has a fourth width, the fourth width is greater than the third width, and a difference value between the fourth width and the third width is a second difference value;
the first difference value is greater than or equal to the second difference value; and
a first included angle is defined between the first openings and a bottom surface of the first optical film layer, a second included angle is defined between the second openings and the bottom surface of the first optical film layer, the first included angle and the second included angle are both less than 90 degrees, and the first included angle is less than or equal to the second included angle.

In the display panel provided by an embodiment of the present disclosure, a number of the first sub-pixels per unit area is same as a number of the second sub-pixels per unit area, and an area of the first sub-pixels is greater than an area of the second sub-pixels.

In the display panel provided by an embodiment of the present disclosure, a spacing between any two adjacent first sub-pixels is less than a spacing between any two adjacent second sub-pixels.

In the display panel provided by an embodiment of the present disclosure, a center of the first openings corresponds to a center of the first sub-pixels, and a center of the second openings corresponds to a center of the second sub-pixels.

The display panel provided by an embodiment of the present disclosure further includes:
a thin film transistor structural layer disposed on the substrate;
an anode disposed on one side of the thin film transistor structural layer away from the substrate;
a pixel definition layer disposed on one side of the anode away from the thin film transistor structural layer, wherein, the pixel definition layer is provided with a plurality of first pixel openings and a plurality of second pixel openings, the first sub-pixels are defined in the first pixel openings, and the second sub-pixels are defined in the second pixel openings; and
a cathode disposed on one side of the pixel definition layer away from the anode.

The display panel provided by an embodiment of the present disclosure further includes a groove penetrating a part of the substrate.

The display panel provided by an embodiment of the present disclosure further includes:
an encapsulation layer disposed on one side of the first sub-pixels and the second sub-pixels away from the substrate.

The display panel provided by an embodiment of the present disclosure further includes:
a touch control layer disposed on one side of the encapsulation layer away from the first sub-pixels and the second sub-pixels.

In the display panel provided by an embodiment of the present disclosure, the first sub-pixels include one of red sub-pixels, green sub-pixels, or blue sub-pixels, and the second sub-pixels include one of the red sub-pixels, the green sub-pixels, or the blue sub-pixels.

Beneficial effect: the embodiments of the present disclosure provide the display panel, which includes the first display area and the second display area. The first display area surrounds at least a part of the second display area. The display panel includes the substrate, the light-emitting layer, and the optical structural layer. The light-emitting layer is disposed on the substrate and includes the plurality of first sub-pixels and the plurality of second sub-pixels. The first sub-pixels correspond to the first display area. The second sub-pixels correspond to the second display area. The optical structural layer is disposed on one side of the light-emitting layer away from the substrate. The light concentrating ability of the optical structural layer corresponding to the first display area is less than the light concentrating ability of the optical structural layer corresponding to the second display area. In the embodiments of the present disclosure, by disposing the optical structural layer on the light-emitting layer and making the light concentrating ability of the optical structural layer corresponding to the first display area be less than the light concentrating ability of the optical structural layer corresponding to the second display area, an ability of the optical structural layer corresponding to the second display area to concentrate light emitted from the second sub-pixels to a front viewing angle is greater than an ability of the optical structural layer corresponding to the first display area to concentrate light emitted from the first sub-pixels to the front viewing angle. Brightness of the second display area at the front viewing angle can be improved, and brightness of the second display area at a large viewing angle can be reduced. Therefore, a problem of brighter visual brightness at the large viewing angle in the second display area than in the first display area can be improved.

### DESCRIPTION OF DRAWINGS

The accompanying figures to be used in the description of embodiments of the present disclosure will be described in brief to more clearly illustrate the technical solutions of the embodiments. The accompanying figures described below are only part of the embodiments of the present disclosure, from which those skilled in the art can derive further figures without making any inventive efforts.
FIG 1 is a schematic planar structural diagram of a display panel according to an embodiment of the present disclosure.
FIG. 2 is a first schematic cross-sectional structural diagram taken along a direction of B-B1 in FIG 1.
FIG 3 is a schematic enlarged diagram of a first display area in FIG 2.
FIG. 4 is a schematic enlarged diagram of a second display area in FIG 2.
FIG 5 is a schematic arrangement diagram of first sub-pixels and second sub-pixels according to an embodiment of the present disclosure.
FIG. 6 is a second schematic cross-sectional structural diagram taken along the direction of B-B1 in FIG 1.
FIG 7 is a schematic enlarged diagram of the first display area in FIG 6.
FIG. 8 is a schematic enlarged diagram of the second display area in FIG 6.
FIG 9 is a third schematic cross-sectional structural diagram taken along the direction of B-B1 in FIG 1.
FIG. 10 is a relation chart between viewing angles and light intensities according to an embodiment of the present disclosure.

### DETAILED DESCRIPTION OF PREFERRED EMBODIMENTS

In order to make the purpose, technical solutions, and advantages of the present disclosure clearer, the following further describes the present disclosure in detail with reference to the drawings. Please refer to the drawings, in which the same reference numerals represent the same components. The following description is based on the specific embodiments of the present disclosure as illustrated, and should not be considered as limiting other specific embodiments not specifically described herein. As used in this specification, the word "embodiment" means an example, instance, or illustration.

In the description of the present disclosure, it should be understood that terms such as "center", "longitudinal", "lateral", "length", "width", "thickness", "upper", "lower", "front", "rear", "left", "right", "vertical", "horizontal", "top", "bottom", "inside", "outside", "clockwise", "counter-clockwise", as well as derivative thereof should be construed to refer to the orientation as described or as shown in the drawings under discussion. These relative terms are for convenience of description, do not require that the present disclosure be constructed or operated in a particular orientation, and shall not be construed as causing limitations to the present disclosure. In addition, terms such as "first" and "second" are used herein for purposes of description and are not intended to indicate or imply relative importance or implicitly indicating the number of technical features indicated. Thus, features limited by "first" and "second" are intended to indicate or imply including one or more than one these features. In the description of the present disclosure, "a plurality of" relates to two or more than two, unless otherwise specified.

This embodiment of the present disclosure provides a display panel. It will be described in detail in the following. It should be noted that an order of description in the following embodiments is not meant to limit a preferred order of the embodiments.

In order to realize full screen display, cameras of current OLED display panels are disposed under display panels. When a camera function is used, a display function is turned off, and when the display function is used, an under-screen camera area displays, that is, a camera under panel (CUP) technique. However, regarding the OLED display panels having under-screen cameras, in light-emitting areas above a projection of the cameras, a light intensity will be lost by about 50% when external light passes through a cathode. A light loss of the cathode directly affects photo effects, so it is necessary to improve a cathode structure in this area to improve light transmittance. In order to solve a problem of lower transmittance when the external light passes through the cathode and affecting normal imaging of the under-screen cameras while ensuring a display area above the cameras to display normally, for products having the under-screen cameras, in the display area above the cameras, the cathode uses a transparent electrode, and meanwhile, a pixel density is reduced, or the pixel density is not changed but a pixel area is reduced. However, a problem of brighter visual brightness at a large viewing angle in a second display area that has a photosensitive electronic component than in a first display area occurs.

The embodiments of the present disclosure provide a display panel, which includes a first display area and a second display area. The first display area surrounds at least a part of the second display area. The display panel includes a substrate, a light-emitting layer, and an optical structural layer. Wherein, the light-emitting layer is disposed on the substrate. The light-emitting layer includes a plurality of first sub-pixels and a plurality of second sub-pixels. The first sub-pixels correspond to the first display area. The second sub-pixels correspond to the second display area. The optical structural layer is disposed on one side of the light-emitting layer away from the substrate. A light concentrating ability of the optical structural layer corresponding to the first display area is less than a light concentrating ability of the optical structural layer corresponding to the second display area. In the embodiments of the present disclosure, by disposing the optical structural layer on the light-emitting layer and making the light concentrating ability of the optical structural layer corresponding to the first display area be less than the light concentrating ability of the optical structural layer corresponding to the second display area, an ability of the optical structural layer corresponding to the second display area to concentrate light emitted from the second sub-pixels to a front viewing angle is greater than an ability of the optical structural layer corresponding to the first display area to concentrate light emitted from the first sub-pixels to the front viewing angle. Brightness of the second display area at the front viewing angle can be improved, and brightness of the second display area at the large viewing angle can be reduced. Therefore, a problem of brighter visual brightness at the large viewing angle in the second display area than in the first display area can be improved.

It should be understood that the second display area in the embodiments is an area corresponding to the photosensitive electronic component, which includes but is not limited to cameras.

It should be noted that the light concentrating ability mentioned in the embodiments refers to an ability to concentrate light emitted from sub-pixels after passing through the optical structural layer, which can be specifically embodied as at least one of differences in widths between orthographic projections of openings of the optical structural layer on the substrate and orthographic projections of the sub-pixels on the substrate, ranges of included angles between a first optical film layer of the optical structural layer and a bottom surface of the optical structural layer, or ranges of refractive indexes of a second optical film layer of the optical structural layer. The light concentrating ability will be explained in detail below.

The display panel of the present disclosure will be described in detail below in conjunction with specific embodiments.

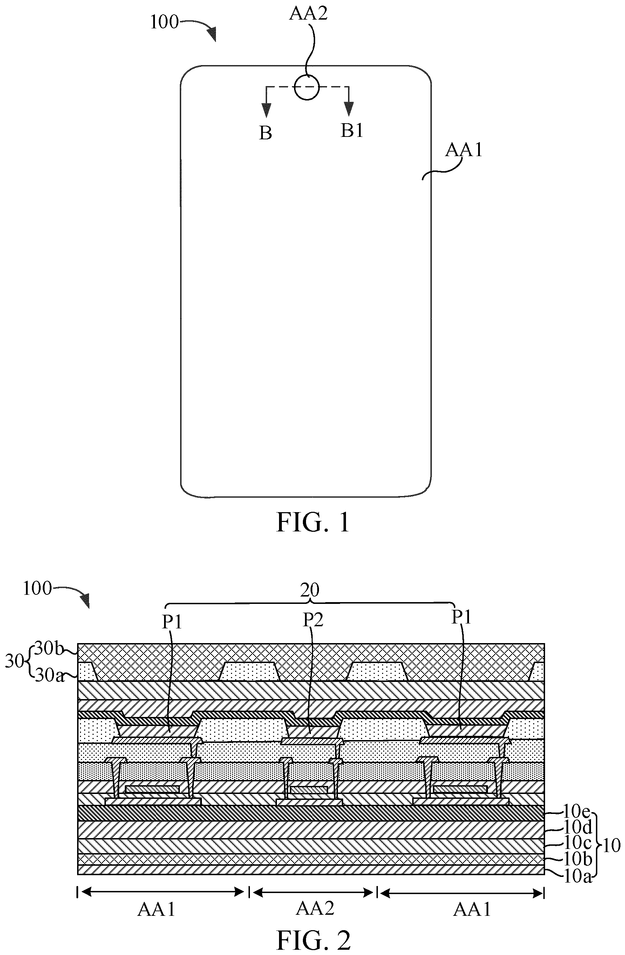

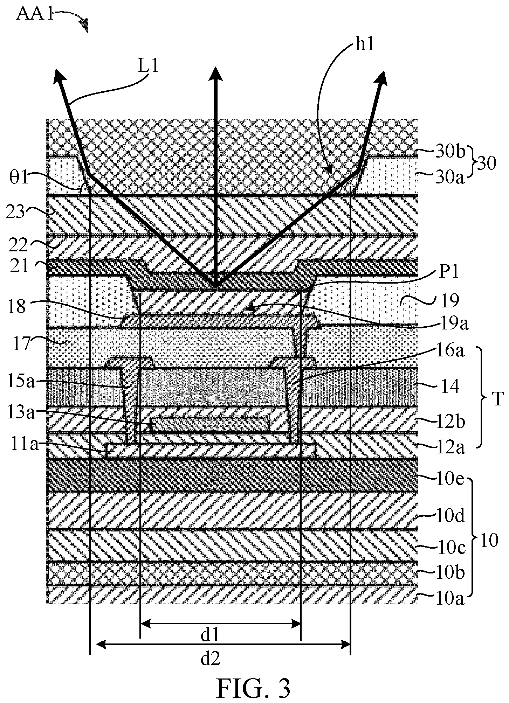

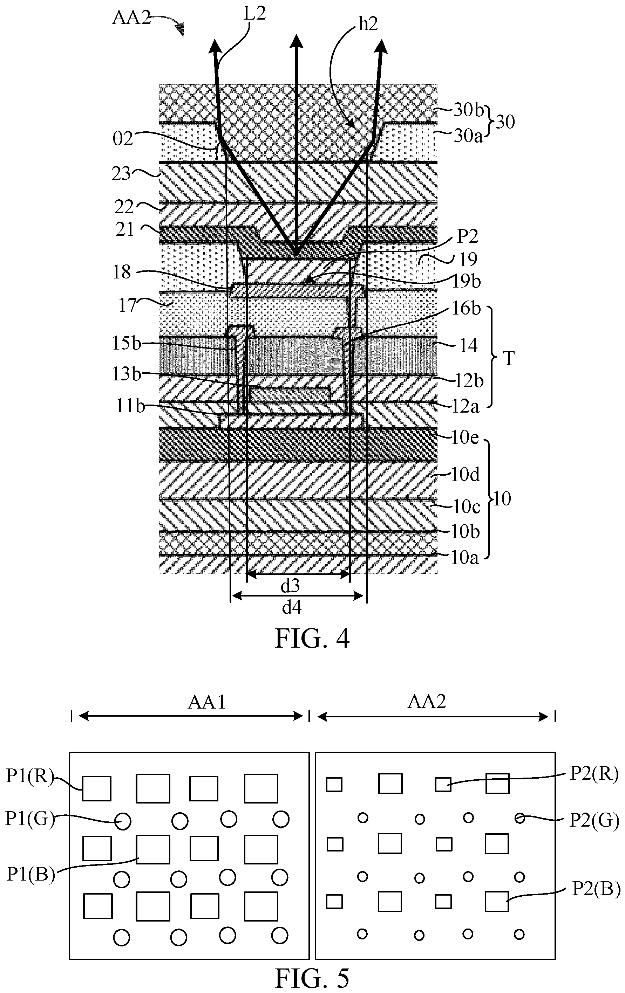

Referring to FIGs. 1 to 4, FIG 1 is a schematic planar structural diagram of the display panel according to an embodiment of the present disclosure, FIG 2 is a first schematic cross-sectional structural diagram taken along a direction of B-B1 in FIG 1., FIG 3 is a schematic enlarged diagram of a first display area in FIG 2, and FIG 4 is a schematic enlarged diagram of a second display area in FIG 2. The display panel 100 includes a first display area AA1 and a second display area AA2, and the first display area AA1 surrounds at least a part of the second display area AA2. The display panel 100 includes a substrate 10, a light-emitting layer 20, and an optical structural layer 30. Wherein, the light-emitting layer 20 is disposed on the substrate 10. The light-emitting layer 20 includes a plurality of first sub-pixels P1 and a plurality of second sub-pixels P2. The first sub-pixels P1 correspond to the first display area AA1. The second sub-pixels P2 correspond to the second display area AA2. The optical structural layer 30 is disposed on one side of the light-emitting layer 20 away from the substrate 10. A light concentrating ability of the optical structural layer 30 corresponding to the first display area AA1 is less than a light concentrating ability of the optical structural layer 30 corresponding to the second display area AA2. In the embodiment of the present disclosure, by disposing the optical structural layer 30 on the light-emitting layer 20 and making the light concentrating ability of the optical structural layer 30 corresponding to the first display area AA1 be less than the light concentrating ability of the optical structural layer 30 corresponding to the second display area AA2, an ability of the optical structural layer 30 corresponding to the second display area AA2 to concentrate light emitted from the second sub-pixels P2 to a front viewing angle is greater than an ability of the optical structural layer 30 corresponding to the first display area AA1 to concentrate light emitted from the first sub-pixels P1 to the front viewing angle. Brightness of the second display area AA2 at the front viewing angle can be improved, and brightness of the second display area AA2 at the large viewing angle can be reduced. Therefore, a problem of brighter visual brightness at the large viewing angle in the second display area AA2 than in the first display area AA1 can be improved.

It should be noted that the first display area AA1 surrounding at least the part of the second display area AA2 mentioned in the embodiment refers to that the first display area AA1 may completely surround the second display area AA2, or the first display area AA1 may only surround a part of the second display area AA2. The embodiment takes the first display area AA1 completely surrounding the second display area AA2 as an example for description, but is not limited to this.

In the embodiment of the present disclosure, at a predetermined distance, an irradiation range of light emitted from the first sub-pixels P1 and passing through the optical structural layer 30 corresponding to the first display area AA1 is a first irradiation range. An irradiation range of light emitted from the second sub-pixels P2 and passing through the optical structural layer 30 corresponding to the second display area AA2 is a second irradiation range. Wherein, the first irradiation range is greater than the second irradiation range. That is, in this embodiment, a light-emitting angle of the optical structural layer 30 corresponding to the first display area AA1 is greater than a light-emitting angle of the optical structural layer 30 corresponding to the second display area AA2. In this embodiment, irradiation ranges of the sub-pixels are adjusted by a structure of the optical structural layer 30, which allow the irradiation range of light emitted from the first sub-pixels P1 and passing through the optical structural layer 30 corresponding to the first display area AA1 to be greater than the irradiation range of light emitted from the second sub-pixels P2 and passing through the optical structural layer 30 corresponding to the second display area AA2. Therefore, brightness of the second display area AA2 at the front viewing angle can be improved, and brightness of the second display area AA2 at the large viewing angle can be reduced. Therefore, the problem of brighter visual brightness at the large viewing angle in the second display area AA2 than in the first display area AA1 can be improved.

Optionally, in some embodiments, the first irradiation range is less than or equal to 180 degrees, and the second irradiation range is less than 160 degrees. For example, the first irradiation range may be any one of 30 degrees, 45 degrees, 60 degrees, 90 degrees, 120 degrees, 150 degrees, or 180 degrees. The second irradiation range may be any one of 30 degrees, 45 degrees, 60 degrees, 90 degrees, 120 degrees, 150 degrees, or 160 degrees.

Further, the optical structural layer 30 includes a first optical film layer 30a and a second optical film layer 30b. A refractive index of the first optical film layer 30a is less than a refractive index of the second optical film layer 30b. The first optical film layer 30a includes a plurality of first openings h1 and a plurality of second openings h2. The first openings h1 correspond to the first sub-pixels P1. The second openings h2 correspond to the second sub-pixels P2. The second optical film layer 30b is disposed on one side of the first optical film layer 30a away from the light-emitting layer 20, and fills the first openings h1 and the second openings h2.

The optical structural layer 30 in the embodiment of the present disclosure includes the first optical film layer 30a and the second optical film layer 30b, the refractive index of the first optical film layer 30a is less than the refractive index of the second optical film layer 30b, and the first optical film layer 30a includes the plurality of first openings h1 and the plurality of second openings h2. Therefore, the light emitted from the first sub-pixels P1 can be totally reflected at side walls of the first openings h1 to realize light extraction, and the light emitted from the second sub-pixels P2 can be totally reflected at side walls of the second openings h2 to realize light extraction.

Optionally, in some embodiments, the side walls of the first openings h1 have a first dot microstructure, the side walls of the second openings h2 have a second dot microstructure, and the first dot microstructure and the second dot microstructure are lens structures. Wherein, the first dot microstructure consists of a plurality of first protrusions, and a height of the first protrusions is gradually increased in a direction from one side adjacent to the substrate 10 to another side away from the substrate 10. The second dot microstructure consists of a plurality of second protrusions, and a height of the second protrusions is gradually increased in the direction from one side adjacent to the substrate 10 to another side away from the substrate 10. The height of the first protrusions is less than the height of the second protrusions. The side walls of the first openings h1 are provided with the first dot microstructure, the side walls of the second openings h2 are provided with the second dot microstructure, and the height of the first protrusions is less than the height of the second protrusions, so a light concentrating ability of the side walls of the first openings h1 is less than a light concentrating ability of the second openings h2. Therefore, a second front viewing brightness in the second display area AA2 is greater than a first front viewing brightness in the first display area AA1. Therefore, brightness of the second display area AA2 at the front viewing angle can be improved, and brightness of the second display area AA2 at the large viewing angle can be reduced. Therefore, the problem of brighter visual brightness at the large viewing angle in the second display area AA2 than in the first display area AA1 can be further improved.

In some embodiments, an orthographic projection of the first sub-pixels P1 on the substrate 10 has a first width d1, an orthographic projection of the first openings h1 on the substrate 10 has a second width d2, the second width d2 is greater than the first width d1, and a difference value between the second width d2 and the first width d1 is a first difference value ΔD1. An orthographic projection of the second sub-pixels P2 on the substrate 10 has a third width d3, an orthographic projection of the second openings h2 on the substrate 10 has a fourth width d4, the fourth width d4 is greater than the third width d3, and a difference value between the fourth width d4 and the third width d3 is a second difference value ΔD2. Wherein, the first difference value ΔD1 is greater than the second difference value ΔD2.

In the embodiment, since the first difference value ΔD1 is greater than the second difference value ΔD2, an ability to concentrate second rays of light L2 emitted from the second sub-pixels P2 and passing through the side walls of the second openings h2 is better than an ability to concentrate first rays of light L1 emitted from the first sub-pixels P1 and passing through the side walls of the first openings h1. That is, an ability of the optical structural layer 30 corresponding to the second display area AA2 to concentrate the second rays of light L2 emitted from the second sub-pixels P2 to the front viewing angle is greater than an ability of the optical structural layer 30 corresponding to the first display area AA1 to concentrate the first rays of light L1 emitted from the first sub-pixels P1 to the front viewing angle. Therefore, brightness of the second display area AA2 at the front viewing angle can be improved, and brightness of the second display area AA2 at the large viewing angle can be reduced. Therefore, the problem of brighter visual brightness at the large viewing angle in the second display area AA2 than in the first display area AA1 can be improved.

Further, the first difference value ΔD1 is greater than 1.5 µm and is less than or equal to 5 µm (1.5 µm≤AD1≤5 µm), and the second difference value ΔD2 is less than or equal to 1.5 µm (ΔD2≤1.5 µm). Preferably, 2 µm < ΔD1 < 5 µm, and ΔD2 < 1.5 µm.

In the embodiment of the present disclosure, the first difference value ΔD1 may be any one of 1.5 µm, 1.8 µm, 2.0 µm, 2.5 µm, 3.5 µm, 4 µm, 4.5 µm, or 5 µm. The second difference value ΔD2 may be any one of 0.1 µm, 0.5 µm, 0.8 µm, 1.0 µm, 1.2 µm, or 1.5 µm. In the embodiment, since the first difference value ΔD1 is set in a range of 1.5µm≤ΔD1≤5µm and the second difference value ΔD2 is set in a range of Δ1D2≤1.5µm, the ability to concentrate the second rays of light L2 emitted from the second sub-pixels P2 and passing through the side walls of the second openings h2 is better than the ability to concentrate the first rays of light L1 emitted from the first sub-pixels P1 and passing through the side walls of the first openings h1. That is, the ability of the optical structural layer 30 corresponding to the second display area AA2 to concentrate the second rays of light L2 emitted from the second sub-pixels P2 to the front viewing angle is greater than the ability of the optical structural layer 30 corresponding to the first display area AA1 to concentrate the first rays of light L1 emitted from the first sub-pixels P1 to the front viewing angle. Therefore, brightness of the second display area AA2 at the front viewing angle can be improved, and brightness of the second display area AA2 at the large viewing angle can be reduced. Therefore, the problem of brighter visual brightness at the large viewing angle in the second display area AA2 than in the first display area AA1 can be further improved.

In some embodiments, a first included angle q1 is defined between the first openings h1 and a bottom surface of the first optical film layer 30a. A second included angle q2 is defined between the second openings h2 and the bottom surface of the first optical film layer 30a. The first included angle q1 and the second included angle q2 are both less than 90 degrees. The first included angle q1 is less than or equal to the second included angle q2. Since the first included angle q1 is less than or equal to the second included angle q2, the ability to concentrate the second rays of light L2 emitted from the second sub-pixels P2 and passing through the side walls of the second openings h2 is better than the ability to concentrate the first rays of light L1 emitted from the first sub-pixels P1 and passing through the side walls of the first openings h1. That is, the ability of the optical structural layer 30 corresponding to the second display area AA2 to concentrate the second rays of light L2 emitted from the second sub-pixels P2 to the front viewing angle is greater than the ability of the optical structural layer 30 corresponding to the first display area AA1 to concentrate the first rays of light L1 emitted from the first sub-pixels P1 to the front viewing angle. Therefore, brightness of the second display area AA2 at the front viewing angle can be improved, and brightness of the second display area AA2 at the large viewing angle can be reduced. Therefore, the problem of brighter visual brightness at the large viewing angle in the second display area AA2 than in the first display area AA1 can be further improved.

Referring to FIG 5, FIG 5 is a schematic arrangement diagram of the first sub-pixels and the second sub-pixels according to an embodiment of the present disclosure. In some embodiments, a number of the first sub-pixels P1 per unit area is same as a number of the second sub-pixels P2 per unit area. An area of any one of the first sub-pixels P1 is greater than an area of any one of the second sub-pixels P2. (Sub-pixels displaying a same color is compared herein, and for example, in FIG 5, an area of the first sub-pixels P1 displaying red color is greater than an area of the second sub-pixels P2 displaying red color.) In the embodiment, in order to improve light extraction efficiency in the second display area AA2, the area of the second sub-pixels P2 corresponding to the second display area AA2 is reduced. Since the area of the second sub-pixels P2 is less than the area of the first sub-pixels P1, light transmittance in the second display area AA2 can be improved, thereby improving uniformity of light extraction in the first display area AA1 and the second display area AA2.

In some embodiments, a spacing between any two adjacent first sub-pixels P1 is less than a spacing between any two adjacent second sub-pixels P2. In the embodiment, since the spacing between any two adjacent first sub-pixels P1 is less than the spacing between any two adjacent second sub-pixels P2, the light transmittance in the second display area AA2 can be improved, thereby further improving the uniformity of light extraction in the first display area AA1 and the second display area AA2.

In some embodiments, the first sub-pixels P1 may be any one of red sub-pixels R, green sub-pixels G, or blue sub-pixels B. The second sub-pixels P2 may be any one of the red sub-pixels R, the green sub-pixels G, or the blue sub-pixels B.

In some embodiments, a center of the first openings h1 corresponds to a center of the first sub-pixels P1, and a center of the second openings h2 corresponds to a center of the second sub-pixels P2. In the embodiment, this setting method can ensure that the first rays of light L1 emitted from the first sub-pixels P1 can be uniformly distributed on the side walls at both sides of the first openings h1 and the second rays of light L2 emitted from the second sub-pixels P2 can be uniformly distributed on the side walls at both sides of the second openings h2. Therefore, uniformity of light extraction can be improved, and a brightness difference between the first display area AA1 and the second display area AA2 can be further reduced.

Further, the display panel 100 further includes a thin film transistor structural layer T, an anode 18, a pixel definition layer 19, and a cathode 21.

It should be noted that thin film transistors in the thin film transistor structural layer T in the embodiment may be bottom gate thin film transistors or top gate thin film transistors, or may be single gate thin film transistors or double gate thin film transistors. The present disclosure takes the single gate thin film transistors as an example for description, but it is not limited to this.

The thin film transistor structural layer T includes a first active layer 11a, a second active layer 11b, a first gate electrode 13a, a second gate electrode 13b, a first source electrode 15a, a first drain electrode 16a, a second source electrode 15b, a second drain electrode 16b, a first gate insulating layer 12a, a second gate insulating layer 12b, an interlayer dielectric layer 14, and a first planarization layer 17. Wherein, the first active layer 11a, the first gate electrode 13a, the first source electrode 15a, and the first drain electrode 16a correspond to the first display area AA1. The second active layer 11b, the second gate electrode 13b, the second source electrode 15b, and the second drain electrode 16b correspond to the second display area AA2. In some embodiments, the substrate 10 includes a first flexible layer 10a, a first blocking layer 10b, a second flexible layer 10c, a second blocking layer 10d, and a buffer layer 10e that are stacked in sequence. The first blocking layer 10b is used to prevent water and oxygen from penetrating into a structure above the first blocking layer 10b through one side of the first flexible layer 10a, thereby preventing the display panel from being damaged. In some embodiments, a material of the first blocking layer 10b, the second blocking layer 10d, and the buffer layer 10e includes, but is not limited to, silicon oxides, silicon nitrides, or silicon oxynitrides. For example, the material of the first blocking layer 10b is at least one of SiOₓ, SiNₓ, or SiOₓN_{y}. A material of the first flexible layer 10a may be same as that of the second flexible layer 10c, and may include at least one of PI (polyimide), PET (polyethylene terephthalate), PEN (polyethylene naphthalate), PC (polycarbonate), PES (polyethersulfone), PAR (aromatic fluorotoluene containing polyarylate), or PCO (polycyclic olefin). The buffer layer 10e may be a silicon nitride layer and a silicon oxide layer disposed in a stack. Wherein, the silicon nitride layer is used to prevent water and oxygen from intruding from one side of the second flexible layer 10c, thereby causing damages to film layers above the display panel 100, and the silicon oxide layer is used to protect the thin film transistors above.

The first active layer 11a and the second active layer 11b are disposed on the buffer layer 10e at intervals. A material of the first active layer 11a and the second active layer 11b may be one or a combination of indium gallium zinc oxide, indium zinc tin oxide, or indium gallium zinc tin oxide. Or, the material of the first active layer 11a and the second active layer 11b may also be low temperature polycrystalline oxide (LTPO). A material of the first gate electrode 13a, the second gate electrode 13b, the first source electrode 15a, the first drain electrode 16a, the second source electrode 15b, the second drain electrode 16b may include one or a combination of silver (Ag), magnesium (Mg), aluminum (Al), tungsten (W), copper (Cu), nickel (Ni), chromium (Cr), molybdenum (Mo), titanium (Ti), platinum (Pt), tantalum (Ta), neodymium (Nd), or scandium (Sc), alloys thereof, or nitrides thereof.

The first gate insulating layer 12a covers the first active layer 11a and the second active layer 11b.

The first gate electrode 13a and the second gate electrode 13b are disposed on the first gate insulating layer 12a at intervals. The second gate insulating layer 12b covers the first gate electrode 13a and the second gate electrode 13b. The interlayer dielectric layer 14 covers the second gate insulating layer 12b.

In some embodiments, a material of the first gate insulating layer 12a, the second gate insulating layer 12b, and the interlayer dielectric layer 14 includes one or a combination of silicon oxide, silicon nitride, or silicon oxynitride.

The first planarization layer 17 covers the first source electrode 15a, the first drain electrode 16a, the second source electrode 15b, and the second drain electrode 16b. A material of the first planarization layer 17 may be selected from silicon dioxide, silicon nitride, silicon oxynitride, or a laminate thereof, or an organic material, such as acrylic resins.

The pixel definition layer 19 is disposed on one side of the anode 18 away from the thin film transistor structural layer T. The pixel definition layer 19 has a plurality of first pixel openings 19a and a plurality of second pixel openings 19b. The first sub-pixels P1 are defined in the first pixel openings 19a. The second sub-pixels P2 are defined in the second pixel openings 19b. Wherein, a width of the second pixel openings 19b is less than a width of the first pixel openings 19a.

It can be understood that the width of the first pixel openings 19a is a width of the first pixel openings 19a that is in contact with the anode 18, and the width of the second pixel openings 19b is a width of the second pixel openings 19b that is in contact with the anode 18. In this embodiment, the first width d1 is the width of the first pixel openings 19a, and the third width d3 is the width of the second pixel openings 19b. The cathode 21 is disposed on one side of the pixel definition layer 19 away from the anode 18.

In some embodiment, the display panel 100 further includes an encapsulation layer 22 and a touch control layer 23. The encapsulation layer 22 is disposed on one side of the first sub-pixels P1 and the second sub-pixels P2 away from the substrate 10. Specifically, the encapsulation layer 22 is disposed on the cathode 21. The encapsulation layer 22 may include a first inorganic encapsulation layer, an organic encapsulation layer, and a second inorganic encapsulation layer that are stacked in sequence. A material of the first inorganic encapsulation layer and the second inorganic encapsulation layer may be at least one of SiOₓ, SiNₓ, or SiOₓN_{y}. A material of the organic encapsulation layer may be selected from epoxy resin, polyimide (PI), polyethylene terephthalate (PET), polycarbonate (PC), polyethylene (PE), polyacrylate, etc.

The touch control layer 23 is disposed on one side of the encapsulation layer 22 away from the first sub-pixels P1 and the second sub-pixels P2. The touch control layer 23 may include an inorganic silicon layer, a touch unit, and an organic planarization layer. Wherein, the touch unit is embedded in the inorganic silicon layer and may be a double-layered structure, and a material of the touch unit may be a laminate of titanium, aluminum, and titanium. The touch unit is used to realize capacitive touch control.

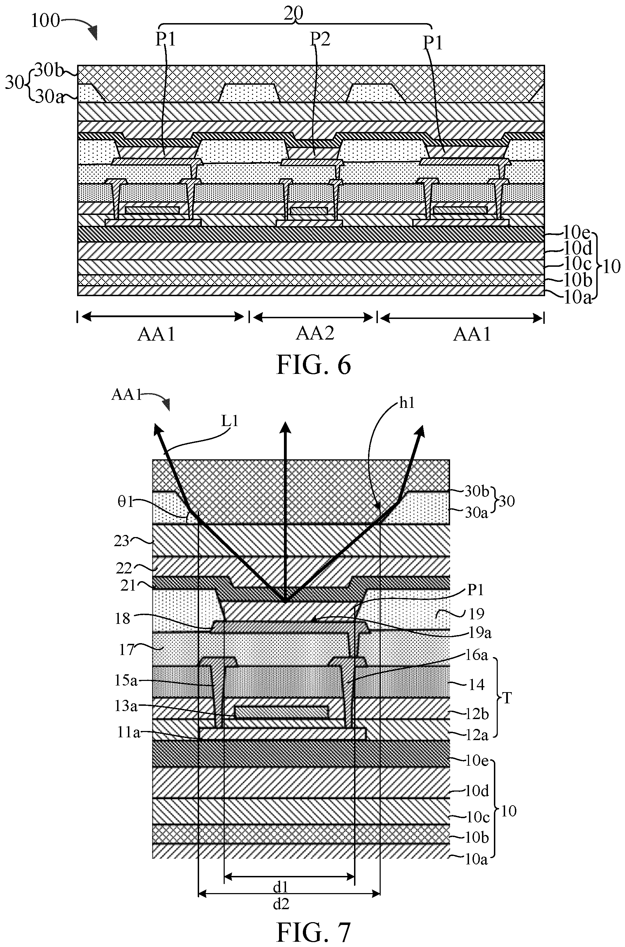

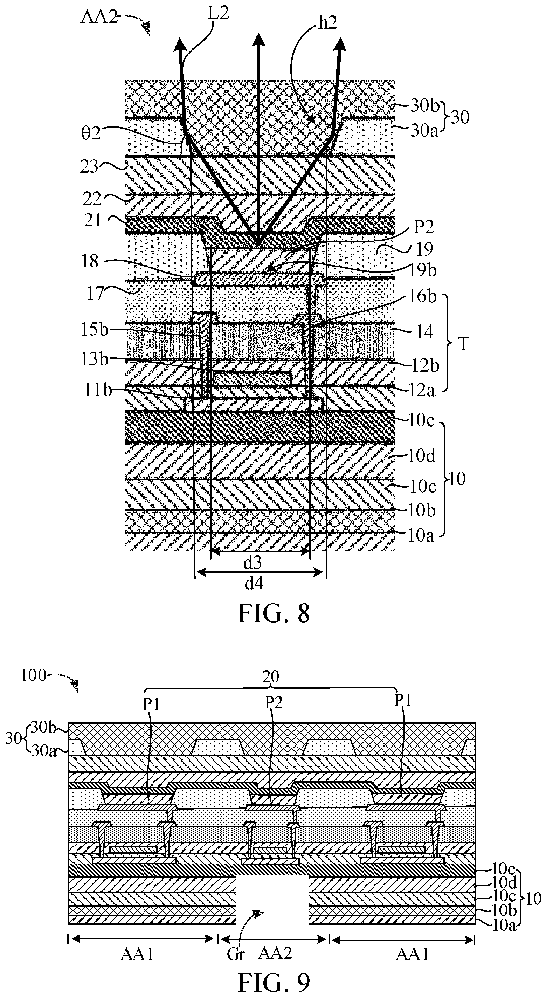

Referring to FIGs. 1 and 6 to 8, FIG 6 is a second schematic cross-sectional structural diagram taken along the direction of B-B1 in FIG 1, FIG 7 is a schematic enlarged diagram of the first display area in FIG 6, and FIG 8 is a schematic enlarged diagram of the second display area in FIG 6. The first included angle q1 is defined between the first openings h1 and the bottom surface of the first optical film layer 30a. The second included angle q2 is defined between the second openings h2 and the bottom surface of the first optical film layer 30a. The first included angle q1 and the second included angle q2 are both less than 90 degrees. The first included angle q1 is less than the second included angle q2. Since the first included angle q1 is less than the second included angle q2, the ability to concentrate the second rays of light L2 emitted from the second sub-pixels P2 and passing through the side walls of the second openings h2 is better than the ability to concentrate the first rays of light L1 emitted from the first sub-pixels P1 and passing through the side walls of the first openings h1. That is, the ability of the optical structural layer 30 corresponding to the second display area AA2 to concentrate the second rays of light L2 emitted from the second sub-pixels P2 to the front viewing angle is greater than the ability of the optical structural layer 30 corresponding to the first display area AA1 to concentrate the first rays of light L1 emitted from the first sub-pixels P1 to the front viewing angle. Therefore, brightness of the second display area AA2 at the front viewing angle can be improved, and brightness of the second display area AA2 at the large viewing angle can be reduced. Therefore, the problem of brighter visual brightness at the large viewing angle in the second display area AA2 than in the first display area AA1 can be further improved. Further, the first included angle q1 is greater than or equal to 15 degrees and is less than or equal to 60 degrees (15°≤q1≤60°), and the second included angle q2 is greater than or equal to 60 degrees and less than 90 degrees (60°≤q2<90°). Preferably, the first included angle q1 has a range of 30°<q1<60°, and the second included angle q2 has a range of 70°<q1<85°.

In the embodiment, the first included angle q1 may be 15°, 25°, 30°, 45°, or 60°. The second included angle q2 may be 60°, 70°, 80°, 85°, or 89°. Since values of the first difference value ΔD 1 and the second difference value ΔD2 are same, the first included angle q1 has a range of 15°≤q1≤60°, and the second included angle q2 has a range of 60°≤q1≤90°, the ability to concentrate the second rays of light L2 emitted from the second sub-pixels P2 and passing through the side walls of the second openings h2 is better than the ability to concentrate the first rays of light L1 emitted from the first sub-pixels P1 and passing through the side walls of the first openings h1. That is, the ability of the optical structural layer 30 corresponding to the second display area AA2 to concentrate the second rays of light L2 emitted from the second sub-pixels P2 to the front viewing angle is greater than the ability of the optical structural layer 30 corresponding to the first display area AA1 to concentrate the first rays of light L1 emitted from the first sub-pixels P1 to the front viewing angle. Therefore, brightness of the second display area AA2 at the front viewing angle can be improved, and brightness of the second display area AA2 at the large viewing angle can be reduced. Therefore, the problem of brighter visual brightness at the large viewing angle in the second display area AA2 than in the first display area AA1 can be further improved.

In some embodiments, the orthographic projection of the first sub-pixels P1 on the substrate 10 has the first width d1, the orthographic projection of the first openings h1 on the substrate 10 has the second width d2, the second width d2 is greater than the first width d1, and the difference value between the second width d2 and the first width d1 is the first difference value ΔD1. The orthographic projection of the second sub-pixels P2 on the substrate 10 has the third width d3, the orthographic projection of the second openings h2 on the substrate 10 has the fourth width d4, the fourth width d4 is greater than the third width d3, and the difference value between the fourth width d4 and the third width d3 is the second difference value ΔD2. Wherein, the first difference value ΔD1 is greater than or equal to the second difference value ΔD2. The problem of brighter visual brightness at the large viewing angle in the second display area AA2 than in the first display area AA1 can be further improved.

In some embodiments, the first optical film layer 30a has a first refractive index n1. The second optical film layer 30b corresponding to the first display area AA1 has a second refractive index n2. The second optical film layer 30b corresponding to the second display area AA2 has a third refractive index n3. Wherein, a refractive index of the second optical film layer 30b corresponding to the first display area AA1 is less than a refractive index of the second optical film layer 30b corresponding to the second display area AA2.

Further, the refractive index n2 of the second optical film layer 30b corresponding to the first display area AA1 is greater than or equal to 1.25 and is less than or equal to 1.65 (1.25≤n2≤1.65), and the refractive index n3 of the second optical film layer 30b corresponding to the second display area AA2 is greater than or equal to 1.5 and is less than or equal to 1.9 (1.5≤n3≤1.9). Preferably, the refractive index n2 of the second optical film layer 30b corresponding to the first display area AA1 has a range of 1.55<n2<1.65, and the refractive index n3 of the second optical film layer 30b corresponding to the second display area AA2 has a range of 1.6<n3<1.85.

In the embodiment, the refractive index n2 of the second optical film layer 30b corresponding to the first display area AA1 may be 1.25, 1.35, 1.45, 1.55, or 1.65, and the refractive index n3 of the second optical film layer 30b corresponding to the second display area AA2 may be 1.6, 1.75, 1.8, 1.85, or 1.9.

In this embodiment, the refractive index of the second optical film layer 30b corresponding to the first display area AA1 is less than the refractive index of the second optical film layer 30b corresponding to the second display area AA2. The ability to concentrate the second rays of light L2 emitted from the second sub-pixels P2 and passing through the side walls of the second openings h2 is better than the ability to concentrate the first rays of light L1 emitted from the first sub-pixels P1 and passing through the side walls of the first openings h1. That is, the ability of the optical structural layer 30 corresponding to the second display area AA2 to concentrate the second rays of light L2 emitted from the second sub-pixels P2 to the front viewing angle is greater than the ability of the optical structural layer 30 corresponding to the first display area AA1 to concentrate the first rays of light L1 emitted from the first sub-pixels P1 to the front viewing angle. Therefore, brightness of the second display area AA2 at the front viewing angle can be improved, and brightness of the second display area AA2 at the large viewing angle can be reduced. Therefore, the problem of brighter visual brightness at the large viewing angle in the second display area AA2 than in the first display area AA1 can be further improved.

Further, in some embodiments, the orthographic projection of the first sub-pixels P1 on the substrate 10 has the first width d1, the orthographic projection of the first openings h1 on the substrate 10 has the second width d2, the second width d2 is greater than the first width d1, and the difference value between the second width d2 and the first width d1 is the first difference value ΔD1. The orthographic projection of the second sub-pixels P2 on the substrate 10 has the third width d3, the orthographic projection of the second openings h2 on the substrate 10 has the fourth width d4, the fourth width d4 is greater than the third width d3, and the difference value between the fourth width d4 and the third width d3 is the second difference value ΔD2. Wherein, the first difference value ΔD1 is greater than or equal to the second difference value ΔD2. The first included angle q1 is defined between the first openings h1 and the bottom surface of the first optical film layer 30a. The second included angle q2 is defined between the second openings h2 and the bottom surface of the first optical film layer 30a. The first included angle q1 and the second included angle q2 are both less than 90 degrees. The first included angle q1 is less than or equal to the second included angle q2.

Since the first difference value ΔD1 is greater than or equal to the second difference value ΔD2, the first included angle q1 is less than or equal to the second included angle q2, and the refractive index of the second optical film layer 30b corresponding to the first display area AA1 is less than the refractive index of the second optical film layer 30b corresponding to the second display area AA2, the brightness of the second display area AA2 at the front viewing angle can be improved, and the brightness of the second display area AA2 at the large viewing angle can be reduced. Therefore, the problem of brighter visual brightness at the large viewing angle in the second display area AA2 than in the first display area AA1 can be further improved.

Referring to FIG 9, FIG 9 is a third schematic cross-sectional structural diagram taken along the direction of B-B1 in FIG 1. In the embodiment, the display panel 100 also includes a groove Gr penetrating a part of the substrate 10. Specifically, the groove Gr penetrates through the first flexible layer 10a, the first blocking layer 10b, the second flexible layer 10c, and the second blocking layer 10d. The photosensitive electronic component is disposed in a part corresponding to the groove Gr. In this embodiment, since the photosensitive electronic component is disposed in the part corresponding to the groove Gr, light transmittance of the photosensitive electronic component is increased, thereby further reducing the brightness difference between the first display area AA1 and the second display area AA2.

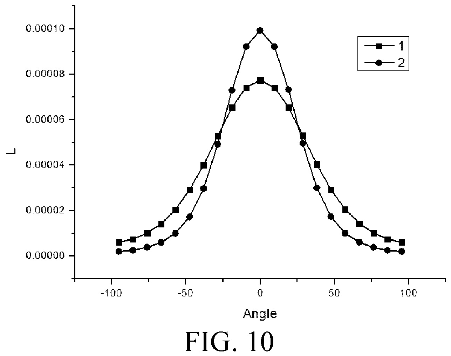

Referring to FIG 10, FIG 10 is a relation chart between viewing angles and light intensities according to an embodiment of the present disclosure. The abscissa is the viewing angles (Angle), and the ordinate is the light intensities (L). Wherein, curve 1 is a light intensity change curve in the first display area AA1 under different viewing angles, and curve 2 is a light intensity change curve in the second display area AA2 under different viewing angles. From FIG 10, it can be known that the display panel 100 provided in the embodiments of the present disclosure can improve a light concentrating ability at the front viewing angle in the second display area AA2. The ability to concentrate the second rays of light L2 emitted from the second sub-pixels P2 and passing through the side walls of the second openings h2 is better than the ability to concentrate the first rays of light L1 emitted from the first sub-pixels P1 and passing through the side walls of the first openings h1. That is, an ability of the optical structural layer 30 corresponding to the second display area AA2 to concentrate the second rays of light L2 emitted from the second sub-pixels P2 to the front viewing angle is greater than an ability of the optical structural layer 30 corresponding to the first display area AA1 to concentrate the first rays of light L1 emitted from the first sub-pixels P1 to the front viewing angle. Therefore, brightness of the second display area AA2 at the front viewing angle can be improved, and brightness of the second display area AA2 at the large viewing angle can be reduced. Therefore, the problem of brighter visual brightness at the large viewing angle in the second display area AA2 than in the first display area AA1 can be improved.

The present disclosure has been described with a preferred embodiment thereof. The preferred embodiment is not intended to limit the present disclosure, and it is understood that many changes and modifications to the described embodiment can be carried out without departing from the scope and the spirit of the disclosure that is intended to be limited only by the appended claims.

## Claims

1. A display panel, comprising a first display area and a second display area, wherein the first display area surrounds at least a part of the second display area, and the display panel comprises:
a substrate;
a light-emitting layer disposed on the substrate and comprising a plurality of first sub-pixels and a plurality of second sub-pixels, wherein the first sub-pixels correspond to the first display area, and the second sub-pixels correspond to the second display area; and
an optical structural layer disposed on one side of the light-emitting layer away from the substrate, wherein a light concentrating ability of the optical structural layer corresponding to the first display area is less than a light concentrating ability of the optical structural layer corresponding to the second display area.

2. The display panel according to claim 1, wherein at a predetermined distance, an irradiation range of light emitted from the first sub-pixels and passing through the optical structural layer corresponding to the first display area is a first irradiation range, and an irradiation range of light emitted from the second sub-pixels and passing through the optical structural layer corresponding to the second display area is a second irradiation range; and
the first irradiation range is greater than the second irradiation range.

3. The display panel according to claim 1, wherein the optical structural layer comprises a first optical film layer and a second optical film layer, and a refractive index of the first optical film layer is less than a refractive index of the second optical film layer; and the first optical film layer comprises a plurality of first openings and a plurality of second openings, the first openings correspond to the first sub-pixels, the second openings correspond to the second sub-pixels, and the second optical film layer is disposed on one side of the first optical film layer away from the light-emitting layer and filled in the first openings and the second openings.

4. The display panel according to claim 3, wherein an orthographic projection of the first sub-pixels on the substrate has a first width, an orthographic projection of the first openings on the substrate has a second width, the second width is greater than the first width, and a difference value between the second width and the first width is a first difference value;
an orthographic projection of the second sub-pixels on the substrate has a third width, an orthographic projection of the second openings on the substrate has a fourth width, the fourth width is greater than the third width, and a difference value between the fourth width and the third width is a second difference value; and
the first difference value is greater than the second difference value.

5. The display panel according to claim 4, wherein the first difference value is greater than 1.5 µm and is less than or equal to 5 µm, and the second difference value is less than or equal to 1.5 µm.

6. The display panel according to claim 4, wherein a first included angle is defined between the first openings and a bottom surface of the first optical film layer, a second included angle is defined between the second openings and the bottom surface of the first optical film layer, the first included angle and the second included angle are both less than 90 degrees, and the first included angle is less than or equal to the second included angle.

7. The display panel according to claim 3, wherein a first included angle is defined between the first openings and a bottom surface of the first optical film layer, a second included angle is defined between the second openings and the bottom surface of the first optical film layer, the first included angle and the second included angle are both less than 90 degrees, and the first included angle is less than the second included angle.

8. The display panel according to claim 7, wherein the first included angle is greater than or equal to 15° and is less than or equal to 60°, and the second included angle is greater than 60° and less than 90°.

9. The display panel according to claim 7, wherein an orthographic projection of the first sub-pixels on the substrate has a first width, an orthographic projection of the first openings on the substrate has a second width, the second width is greater than the first width, and a difference value between the second width and the first width is a first difference value;
an orthographic projection of the second sub-pixels on the substrate has a third width, an orthographic projection of the second openings on the substrate has a fourth width, the fourth width is greater than the third width, and a difference value between the fourth width and the third width is a second difference value; and
the first difference value is greater than or equal to the second difference value.

10. The display panel according to claim 3, wherein a refractive index of the second optical film layer corresponding to the first display area is less than a refractive index of the second optical film layer corresponding to the second display area.

11. The display panel according to claim 10, wherein the refractive index of the second optical film layer corresponding to the first display area is greater than or equal to 1.25 and is less than or equal to 1.65, and the refractive index of the second optical film layer corresponding to the second display area is greater than or equal to 1.5 and is less than or equal to 1.9.

12. The display panel according to claim 10, wherein an orthographic projection of the first sub-pixels on the substrate has a first width, an orthographic projection of the first openings on the substrate has a second width, the second width is greater than the first width, and a difference value between the second width and the first width is a first difference value;
an orthographic projection of the second sub-pixels on the substrate has a third width, an orthographic projection of the second openings on the substrate has a fourth width, the fourth width is greater than the third width, and a difference value between the fourth width and the third width is a second difference value;
wherein the first difference value is greater than or equal to the second difference value; and
a first included angle is defined between the first openings and a bottom surface of the first optical film layer, a second included angle is defined between the second openings and the bottom surface of the first optical film layer, the first included angle and the second included angle are both less than 90 degrees, and the first included angle is less than or equal to the second included angle.

13. The display panel according to claim 1, wherein a number of the first sub-pixels per unit area is same as a number of the second sub-pixels per unit area, and an area of the first sub-pixels is greater than an area of the second sub-pixels.

14. The display panel according to claim 1, wherein a spacing between any two adjacent first sub-pixels is less than a spacing between any two adjacent second sub-pixels.

15. The display panel according to claim 3, wherein a center of the first openings corresponds to a center of the first sub-pixels, and a center of the second openings corresponds to a center of the second sub-pixels.

16. The display panel according to claim 1, further comprising:
a thin film transistor structural layer disposed on the substrate;
an anode disposed on one side of the thin film transistor structural layer away from the substrate;
a pixel definition layer disposed on one side of the anode away from the thin film transistor structural layer, wherein the pixel definition layer is provided with a plurality of first pixel openings and a plurality of second pixel openings, the first sub-pixels are defined in the first pixel openings, and the second sub-pixels are defined in the second pixel openings; and
a cathode disposed on one side of the pixel definition layer away from the anode.

17. The display panel according to claim 16, further comprising a groove penetrating a part of the substrate.

18. The display panel according to claim 1, further comprising:
an encapsulation layer disposed on one side of the first sub-pixels and the second sub-pixels away from the substrate.

19. The display panel according to claim 18, further comprising:
a touch control layer disposed on one side of the encapsulation layer away from the first sub-pixels and the second sub-pixels.

20. The display panel according to claim 1, wherein the first sub-pixels comprise one of red sub-pixels, green sub-pixels, or blue sub-pixels, and the second sub-pixels comprise one of the red sub-pixels, the green sub-pixels, or the blue sub-pixels.
